Europäisches Patentamt

European Patent Office

Office européen des brevets

(19)

(11) Publication number: **0 417 294 A1**

## (12) EUROPEAN PATENT APPLICATION
### published in accordance with Art. 158(3) EPC

(21) Application number: 90901090.2

(22) Date of filing: 09.08.89

(86) International application number:
PCT/SU89/00207

(87) International publication number:
WO 90/11673 (04.10.90 90/23)

(51) Int. Cl.⁵: **H05K 3/12**

(30) Priority: 23.03.89 SU 4661276

(43) Date of publication of application:
20.03.91 Bulletin 91/12

(84) Designated Contracting States:
**CH DE FR GB IT LI SE**

(71) Applicant: ZYBIN, Kirill Petrovich
Leningradskoe shosse, 13-104
Moscow, 125171(SU)

Applicant: MAXIMOVSKY, Sergei Nicolaevich
ul. Skakovaya, 34-4-235
Moscow, 125040(SU)

(72) Inventor: ZYBIN, Kirill Petrovich
Leningradskoe shosse, 13-104
Moscow, 125171(SU)
Inventor: MAXIMOVSKY, Sergei Nikolaevich
ul. Skakovaya, 34-4-235
Moscow, 125040(SU)
Inventor: RADUTSKY, Grigory Avramovich
ul. Pervomaiskaya, 66-45
Moscow, 105554(SU)

(74) Representative: Godwin, Edgar James
MARKS & CLERK 57-60 Lincoln's Inn Fields
London, WC2A 3LS(GB)

### (54) METHOD AND DEVICE FOR MAKING INTEGRATED CIRCUITS.

(57) A method of making integrated circuits provides for applying on a sublayer (1), according to a predetermined topology, of circuit elements in the form of pluralities (A,B,C,D) of points arranged in a predetermined coordinate system (x/y) and applied in the form of separate drops (2) of liquid application compounds. The pluralities (A,B,C,D) of points constitute the blank elements for the integrated circuit which are then subjected to heat treatment to obtain the desired integrated circuit. A device for implementing the method comprises consecutively located units (9, 10, 11) for application of liquid compounds provided with capillar nozzles (15) and located in a predetermined coordinate system (x/y), and electrically controlled means for selective shots of drops (2) of liquid application compounds through capillar nozzles (15) on a sublayer (1) placed on a unit (7) intended for fastening the sublayer (1) and mounted on a means (8) for moving the unit (7) for fastening the sublayer (1). The device further comprises a control unit (16) connected to electrically controlled means for selective shots of drops (2) and to a voltage pulse generator (21), a unit (12) for the heat treatment of the applied compounds and means (13) for drying the applied compounds which are located between said units.

FIG.7

# METHOD FOR MANUFACTURING INTEGRATED CIRCUITS AND DEVICE THEREOF

Field of the Invention

The invention relates to manufacturing integrated circuits and, more specifically, to the manufacture of thick-film and high-temperature superconducting integrated circuits.

Background Art

Known in the art is a method for manufacturing integrated circuits, comprising deposition on a substrate of various compounds (suspensions and solutions of metals, metalloids and metal oxides) in accordance with a preset topology to fabricate components of the integrated circuit, with subsequent heat treatment of these components (M.Topfer "Mikroelektronika tolstykh plyonok" /"Thick Film Microelectronics"/. Moscow: MIR Publishers, 1973, pp.23-29, 102-111. - Russian translation). According to this prior art method, compounds are deposited onto the substrate with the aid of masks, produced photographically with subsequent processing into templates of the required topology of the integrated circuit being fabricated. Deposition onto the substrate of certain compounds (suspensions and solutions of metals and metalloids) allows producing, after heat treatment, the required active and passive components of a microelectronic integrated circuit, deposition of other compounds (metal oxides) produces the active components of cryotron circuits.

This prior art method provides high quality integrated circuits but is complicated, because it involves a laborous and time-consuming process of template fabrication, each template suitable only for one specific circuit and requiring special storage conditions, careful use and cleaning after each use. Furthermore, template fabrication requires special technology and hardware systems, along with special squeegees to deposit the compounds via the template without damaging it. This prior art method is especially unsuitable to manufacturing experimental integrated circuits and in small-scale production due to the necessity of providing a complicated and costly template for each new circuit.

Also known in the art is a device for manufacturing integrated circuits (ibid.), comprising substrate holding assemblies, sequentially positioned assemblies for depositing compounds onto the substrate intermingled with assemblies for drying the deposited compounds, a heat treatment assembly, and a means to transport the substrate holding assemblies to the sequentially positioned depositing, drying and heat treating assemblies. The compounds being applied are fed to the depositing assemblies, these latter being provided with squeegees to apply the corresponding compound via the prefabricated template, precisely positioned relative to the substrate. As mentioned, template fabrication involves the use of complicated hardware and special technology, whereas compound deposition by means of squeegees is also a delicate operation because of the danger of damaging an expensive template.

This prior art device is also ineffective for small-scale production of integrated circuits and for manufacturing experimental items.

This invention is to provide a method for manufacturing integrated circuits by depositing compounds onto a substrate and a device thereof, ensuring production of the specified topology of active and passive components without involving fabrication of masks or templates.

Disclosure of the Invention

This is achieved by that in the method for manufacturing integrated circuits, comprising deposition onto a substrate of compounds to form components of integrated circuits of a preset topology with subsequent heat treat ment of the deposited compounds forming components of the integrated circuit, according to this invention, the compounds are deposited onto the substrate as separate droplets to produce a pattern of dots on the substrate, positioned according to a specified system of coordinates, each such pattern of dots constituting the preform of a component of the integrated circuit, with subsequent heat treatment of the component preforms thus produced.

This method provides a discrete dot pattern of the integrated circuit on the substrate, of various compounds, to produce the specified circuit topology, so that subsequent heat treatment results in the production of the required integrated circuit, without using a template or mask, this substantially simplifying the manufacturing of integrated circuits.

The objective of the invention is also achieved by that in the device for manufacturing integrated circuits, comprising substrate holding assemblies, sequentially positioned assemblies for depositing compounds onto the substrate to form components of the integrated circuit, a dried compounds heat treatment assembly, compound drying means positioned between said assemblies, and a transport means to transfer the substrate holding assemblies to the compound depositing assemblies and to the heat treatment assembly, according to this invention, each of the compound depositing assemblies is designed as an array plate with capillary nozzles arranged in a specified system of coordinates and these nozzles communicating with a tank storing the compound being deposited, and is provided with electrically controlled means for selectively ejecting compound droplets from the capillary nozzles and with a controller connected to the electrically controlled means for selective ejection of droplets from the capillary nozzles and driven by a pulse generator connected to this controller.

Designing compound deposition assemblies with an array plate with capillary nozzles arranged therein in a specified system of coordinates, with electrically controlled means for selectively ejecting compound droplets from the capillary nozzles specified and communicating with a tank storing the compound, and with a controller connected to these electrically controlled means and to a pulse generator, allows a dot pattern to be deposited onto the substrate to preform components of the integrated circuit in the form of pluralities of dot patterns. These preforms are produced on the substrate without a mask and are of any configuration, as defined by switching the droplet ejection means under control of the controller.

It is expedient that the electrically controlled means for selective ejection of compound droplets from the capillary nozzles be designed as a system of electrodes of opposite polarity, positioned in one plane parallel to each row of nozzles, to both sides thereof, and connected to the controller, and a permanent magnet layer positioned at the side of capillary nozzles discharge opening in a plane parallel to the plane of the electrodes.

This design configuration provides pulse ejection of a droplet of the compound being deposited (a suspension or solution in a current-conducting liquid), droplets being ejected only by nozzles selected by the controller to produce the desired circuit topology. Using a combination of electrodes and a permanent magnet allows a lower pulse voltage to be used, thus preventing decomposition of the compound being deposited and damage of the electrodes and capillary nozzles.

Brief Description of the Accompanying Drawings

In the following the invention is described with reference to specific embodiments thereof and to the accompanying drawings, wherein:

Fig. 1 schematically shows a fragment of an integrated circuit with a dot pattern or plurality of dots of different compounds deposited thereonto, illustrating the method of this invention;

Fig. 2 shows a conductor on the fragment of an integrated circuit shown in Fig. 1 (enlarged);

Fig. 3 shows a conductor section on the fragment of an integrated circuit shown in Fig. 1, formed by overlapping compound dots (enlarged);

Fig. 4 shows a fragment of a cryotron integrated circuit (enlarged);

Fig. 5 shows a fragment of a microelectronic circuit (enlarged);

Fig. 6 shows the fragment of Fig. 1 after heat processing;

Fig. 7 shows schematically the appearance of the device for manufacturing integrated circuits of this invention;

Fig. 8 shows the VIII-VIII section of the device of Fig. 7 (enlarged);

Fig. 9 shows the IX-IX section of the device of Fig. 7 (enlarged).

Preferred Embodiment

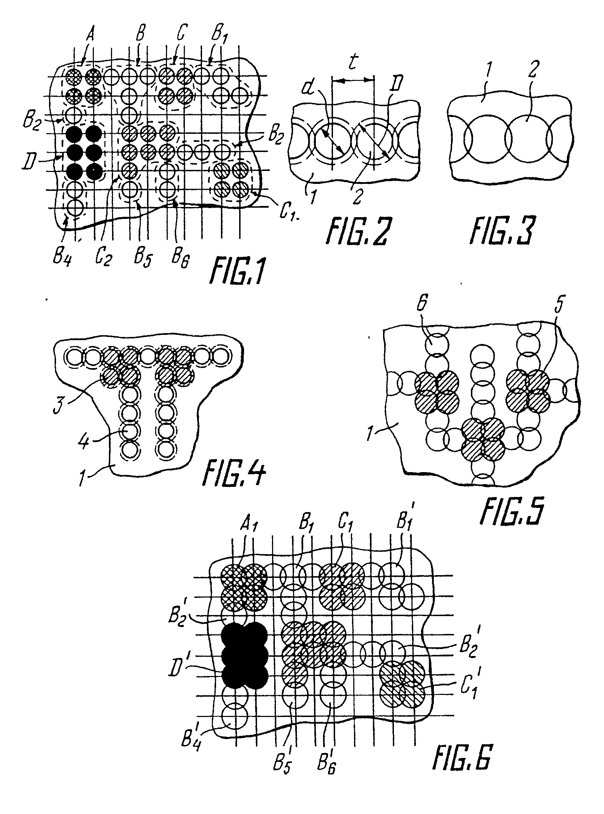

The method of this invention resides in that a substrate 1 (Fig. 1) is used to deposit sequentially thereonto compounds in the form of suspensions and solutions of metals, metalloids and metal oxides in a liquid, as separate droplets to form on this substrate 1 dot patterns A, B, $B_1$ to $B_7$, C, $C_1$ to $C_2$ positioned in a specified system of coordinates x-y. Each of the said dot patterns constitutes an individual circuit component, for instance dot patterns A, C and D form active and passive circuit components with the B dot pattern forming conductors. In this way, a circuit is preformed on the substrate 1 (Fig. 1).

As shown in Fig. 2, current-conducting components of the circuit may be formed by depositing onto the substrate droplets 2 of a metal suspension, the droplet diameter "d" being less than their pitch "t". During subsequent melting of the metal particles after suspension drying this diameter increases to "D". Fig. 3 shows deposition of overlapping droplets.

Fig. 4 shows fabrication of a cryotron integrated circuit by depositing onto the substrate 1 of a plurality of dots 3 of a solution of metal oxides and a plurality of dots 4 of a metal solution. Thereafter the droplets are dried, melted and cooled, thus forming a layer of monocrystal or polycrystal semiconductor (depending on the conditions of heat treatment) at the sites of metal oxides deposition. Immerging such a cryotron circuit in liquid nitrogen makes it suitable for use as an emitter of microwave oscillations, photoreceiver, mixer, etc.

As shown in Fig. 6, a microelectronic integrated circuit is fabricated by depositing onto a semiconducting substrate of a plurality of dots 5 in the form of a metalloid solution droplets and of a plurality of dots 6 in the form of a metal suspension droplets. Thermal treatment of such circuit preforms produces the active and passive components of the circuit, respectively.

The hereinabove mentioned operations, i.e. depositing compounds in the form of separate droplets to form a pattern on the substrate, drying the deposited compounds after each deposition operation, and heat treating after depositing all compounds, result in an integrated circuit, a fragment whereof is illustrated in Fig. 6 with circuit components A', B', $B_1'$ to $B_6'$, C', $C_1'$, D.

The compositions of the suspensions and solutions required to fabricate the passive and active components of integrated circuits, and also the conditions of drying and heat treatment, will not be discussed in detail, because they do not directly relate to this invention and are well known to those skilled in the art.

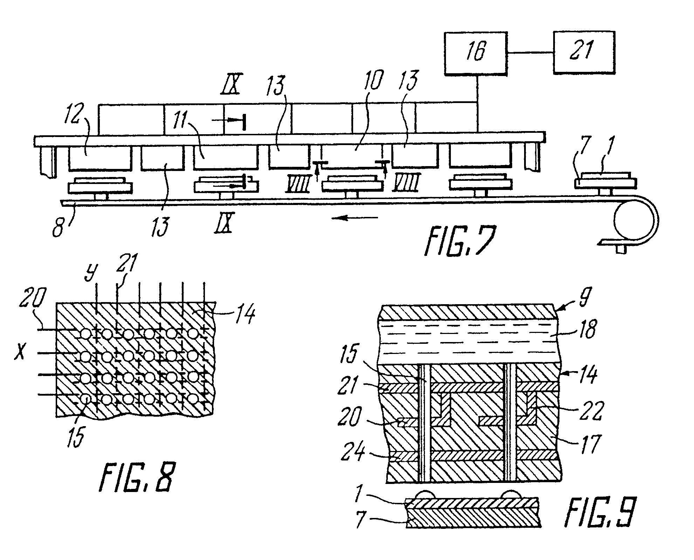

Deposition of separate droplets of compounds onto the substrate 1 may be achieved with any known technique, but the most suitable is the method of this invention, as implemented with the aid of the described herein below device for fabricating integrated circuits, schematically shown in Fig. 7.

The device for manufacturing integrated circuits (Fig. 7) of this invention comprises substrate 1 holding assemblies 7 mounted on a means for their transport - step transporter 8. The device comprises sequentially positioned compounds depositing onto substrate 1 assemblies: metalloids deposition assembly 9, metal oxide solutions deposition assembly 10 and metal suspension deposition assembly 11, and also a heat treatment assembly 12, for instance, and inductor, emitter of electromagnetic radiation, laser, etc. Drying assemblies 13 are positioned between assemblies 9, 10, 11, 12. Obviously, the device may comprise several assemblies 9, 10, 11 each to deposit various compounds. All assemblies are positioned with a pitch equal to the displacement step provided by transporter 8. Step transporter 8 is provided with a drive (not shown) and controller, ensuring precise positioning of the substrate holding assemblies 7 under each compound deposition assembly 9, 10, 11, for instance with the aid of optico-mechanical or laser means and a position-to-number converter with a high resolution. These devices are well known to those skilled in the art, are widely used for precise positioning of masks and templates and will therefore not be discussed in detail herein.

As shown in Fig. 8, each assembly 9, 10 or 11 comprises an array plate 14 with capillary nozzles 15 arranged in parallel rows and forming an x-y coordinate system. Nozzles 15 are designed to selectively eject compound droplets under control of a program stored in the controller 16 (Fig. 7). Each deposition assembly comprises electrically controlled means for selective ejection of compound droplets connected to controller 16. Each nozzle 15 is in a dielectric plate 17, constituting a component part of the array plate 14 and provided with a tank 18 filled with the compound being deposited (suspension or solution in a current-conducting liquid) and communicating with the capillary nozzles 15. The droplet selective ejection means are a plurality of individual electrodes 19 and common electrodes 20 of opposite polarities, positioned in a common plane normal to the capillary nozzles axes to both sides of each row of nozzles, with the common electrodes 20 directly constituting current-carrying buses and connected to the controller 16 and with current-carrying buses 21 of the individual electrodes 19, 20 located on a plane parallel to that of electrodes 19, 20 and connected to the individual electrodes 19 by jumpers 22 (Fig. 9). The current-carrying buses 21 are also connected to the controller 16 and positioned along lines normal to the common electrodes 20 (Fig. 8) so that corresponding rows of electrodes 19, 20 form an x-y grid. Such a design arrangement provides an electrode pair 19, 20 per each nozzle 15 and each electrode pair 19, 20 may be energized or not by a voltage pulse from voltage pulse generator 23, passed by the controller 16.

At the discharge opening side of the nozzles 15, the array plate 14 is provided with a permanent magnet layer 24 (Fig. 9), constituting a component part of the compound selective ejection means.

The direction of step transporter 8 movement is shown by an arrow in Fig. 7.

The device for manufacturing integrated circuits of this invention functions as follows.

Prior to operation, a control program is loaded into the controller 16 to define the sequence of switching electrodes 19, 20 in the electrically controlled means for selective ejection of compound droplets, as determined by the specified topology of the integrated circuit to be manufactured. Obviously, controller 16 is essentially a switching device, for instance an array of keys arranged as a grid identical to the grid of electrodes 19, 20. The controller 16 may also be designed as a reloadable storage of a computer, or as any other programmable device, and may be common to all compound deposition assemblies. It should be noted that the coordinate x-y grid (Fig. 8) is also defined by the controller 16 and may feature a pitch larger than that of the capillary nozzles 15 over the entire area of the substrate or only over certain section thereof.

The tank 18 of the array plate 14 in each deposition assembly 9, 10, 11 is filled with the proper suspension or solution.

The substrate 1 is fitted to the substrate holding assembly 7 and the step transporter 8 is enabled for one step, so that the substrate 1 is positioned under the array plate 14 of the assembly 9 to deposit, for instance, a solution of metalloid. On command from the controller 16, corresponding electrodes 19, 20 receive a voltage pulse from the pulse generator 23, this causing the liquid stored in the tank 18 of this array plate 14 to be ejected in the form of separate droplets by all nozzles 15, the electrodes 19, 20 whereof are connected to the pulse generator 23 via the controller 16. Pulsed ejection of droplets is provided by interaction of the current carried by the electrically conducting liquid filling the capillary nozzles 15 and flowing between electrodes 19, 20, and the permanent magnet layer 24. The result is a pattern of dots in the form of separate compound (metalloid solution) droplets on the substrate 1.

The step transporter 8 is then again enabled for one step and positions the substrate holding assembly 7 under a drying assembly 13 to evaporate the liquid out of the droplets 2. Thereafter the step transporter 8 is yet again enabled for one step and the substrate 1 is positioned below the deposition assembly 10 to receive droplets of a metal oxide solution, the described herein above process is repeated, after which assembly 11 provides deposition of a metal suspension in a similar way. After all compounds have been deposited onto the substrate 1 and dried, a dot pattern (Fig. 1) is produced on the substrate 1 in the form of a plurality of dots representing preforms of components of the integrated circuit and the step transporter 8 is enabled for a single step to position the substrate 1 under the heat treating assembly 12, where the separate droplets are fused together and the necessary physico-chemical transformations take place and convert them into conductors and passive and active components of the integrated circuit. Thereafter, the substrate is cooled (not shown), this resulting in the required physical processes in-the circuit component, and the finished integrated circuit chip with the specified topology and structure of components is thus produced.

Industrial Applicability

This invention can be successfully used in microelectronics and cryotronics, and will be most effective in manufacturing experimental integrated circuit and in small-scale production.

**Claims**

1. A method for manufacturing integrated circuits, comprising deposition onto a substrate (1) according to a predetermined topology of various compounds to create out of them compounds of an integrated circuit, with subsequent heat treatment of these compounds forming integrated circuit components, **characterized** by that the compounds are deposited onto the substrate (1) as separate droplets (2) to produce dot patterns (A, B, C, D) in a specified system of x-y coordinates, wherein each dot pattern (A, B, C, D) constitutes a preform of an individual integrated circuit component, with subsequent heat treatment of the preforms thus produced.

2. A device for manufacturing integrated circuits, comprising substrate (1) holding assemblies (7), sequentially positioned-assemblies (9, 10, 11) to deposit onto substrate (1) compounds to create integrated circuit components therefrom, a heat treating assembly (12) to treat the dried compounds, positioned between said assemblies drying means (13) to dry the deposited compounds, and a transporting means (8) to transport the substrate holding assemblies (7) to the compound depositing assemblies (9, 10, 11), drying means (13) and heat treating assembly (12), **characterized** by that each of the compound depositing assemblies (9, 10, 11) is designed with an array plate (14) with capillary nozzles (15) arranged thereon in a specified system of x-y coordinates, said capillary nozzles (15) communicating with a tank (18) to store the compound to be deposited, and with an electrically controlled means for selective ejection of droplets from the capillary nozzles (15), and also by that it further comprises a controller (16) connected to the electrically controlled means for selective ejection of droplets (2) and to a voltage pulse generator (21).

3. A device as claimed in Claim 2, **characterized** by that the electrically controlled means for selective ejection of droplets (2) from capillary nozzles (15) are designed as a system of oppositely polarized electrodes (19, 20), positioned on a common plane normal to the longitudinal axis of the nozzles (15) and, respectively, to both sides of each row of capillary nozzles (15), and connected to the controller (16), and a permanent magnet layer (24) positioned from the side of the discharge openings of the capillary nozzles (15) on a plane parallel to that containing oppositely polarized electrodes (19, 20).

EP 0 417 294 A1

FIG.1

FIG.2

FIG.3

FIG.4

FIG.5

FIG.6

6

FIG.7

FIG.8

FIG.9

# INTERNATIONAL SEARCH REPORT

International Application No PCT/SU 89/00207

| | |
|---|---|
| **I. CLASSIFICATION OF SUBJECT MATTER** (if several classification symbols apply, indicate all) | |

According to International Patent Classification (IPC) or to both National Classification and IPC

Int. Cl.$^5$    H 05 K 3/12

**II. FIELDS SEARCHED**

| Minimum Documentation Searched [7] | |
|---|---|
| Classification System | Classification Symbols |

Int. Cl.$^4$    H 05 K 3/00, 3/10, 3/12, 3/46, H 01 L 21/00, B 41 J 3/10, 3/12, 3/16, 3/516, B41 F 17/00, B41M 3/00

Documentation Searched other than Minimum Documentation
to the Extent that such Documents are Included in the Fields Searched [8]

**III. DOCUMENTS CONSIDERED TO BE RELEVANT** [9]

| Category [*] | Citation of Document, [11] with indication, where appropriate, of the relevant passages [12] | Relevant to Claim No. [13] |
|---|---|---|
| A | M. Topfer " Mikroelektronika tolstykh plenok", 1973, Mir (Moscow), pages 102-111 | 1 |
| A | DE, B2, 2316177 (Licentia Patent-Verwal-tungs GmbH), 30 January 1975 (30.01.75), the abstract | 1 |
| A | DE, B2, 2316176 (Licentia Patent-Verwal-tungs GmbH), 30 January 1975 (30.01.75), the abstract | 1 |
| A | US, A, 3966035 (Robert L. Erickson), 29 June 1976 (29.06.76) , the abstract | 2 |
| A | US, A, 4272200 (International Business Machines Corporation), 9 June 1981 (09.06.81), the abstract | 2 |

---

\* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

**IV. CERTIFICATION**

| Date of the Actual Completion of the International Search | Date of Mailing of this International Search Report |
|---|---|
| 28 February 1990 (28.02.90) | 14 March 1990 (14.03.90) |

| International Searching Authority | Signature of Authorized Officer |
|---|---|
| ISA/SU | |

Form PCT/ISA/210 (second sheet) (January 1985)